# EUROPEAN PATENT SPECIFICATION

(11) **EP 0 498 505 B1**
(45) Date of publication and mention of the grant of the patent: **16.10.1996**
(21) Application number: 92200299.3
(22) Date of filing: 03.02.1992
(51) Int. Cl.: C08G 59/06, C08J 5/24, H01B 3/40

(54) **Epoxy resin composition for use in electrical laminates**
Epoxydharzzusammensetzungen für elektrische Schichtstoffe
Compositions de résines époxydes et leur utilisation dans les stratifiés électriques

(30) Priority: 06.02.1991 JP 100595/91
(43) Date of publication of application: 12.08.1992
(73) Proprietor: SHELL INTERNATIONALE RESEARCH MAATSCHAPPIJ B.V., 2596 HR Den Haag (NL)
(72) Inventor: Maeda, Kazuo, c/o Yuka Shell Epoxy K.K., Yokkaichi City, Mie Prefecture (JP); Watanabe, Takamasa, c/o Yuka Shell Epoxy K.K., Yokkaichi City, Mie Prefecture (JP); Fukuzawa, Takao, c/o Yuka Shell Epoxy K.K., Yokkaichi City, Mie Prefecture (JP); Ohta, Masayuki, c/o Yuka Shell Epoxy K.K., Yokkaichi City, Mie Prefecture (JP)

(56) References cited:
- EP-A- 0 158 915
- WORLD PATENTS INDEX LATEST Derwent Publications Ltd., London, GB; AN 89-344647
- PATENT ABSTRACTS OF JAPAN vol. 012, no. 482 (C-553)(3329) 15 December 1988

## Description

The present invention relates to epoxy resin compositions capable of providing cured products having an excellent impregnation ability particularly into glass cloth, as well as an excellent prepreg stability and further exhibiting an excellent curing speed, thermal resistance, measling resistance, drilling workability and adhesion to metal. The present epoxy resin compositions can be advantageously used for the manufacture of electrical laminates such as copper-plated, laminated epoxy resin sheets for use in printed-wiring boards, particularly in multi-layer printed-wiring boards.

In recent years, high condensation technology of printed-wiring boards has made a remarkable advancement, accompanied by miniaturization of electronic appliances. Therefore the base materials of printed-wiring boards, require improved thermal resistance and measling resistance.

Well known additives for improving thermal resistance of cured epoxy resin products, are polyfunctional epoxy resins such as phenol novolak-type epoxy resins, cresol novolak-type epoxy resins, and triglycidyl-etherified compounds of para-aminophenol. However, even with the addition of the above-mentioned polyfunctional resins, the physical properties of the cured products were still unsatisfactory.

Also, it is known to improve the thermal resistance and curing rate of epoxy resin compositions, by reacting phenol novolak-type epoxy resins or cresol novolak-type epoxy resins and bisphenol A-type epoxy resins with polyhydric phenolic compounds. However, when subjecting the laminated sheets comprising such epoxy resins to a treatment with boiling water, followed by a treatment in a soldering bath, undesirable phenomena as "blisters", "peeling", "measling", and "creasing" occur and further drilling workability becomes deteriorated due to the resulting hardening and brittleness of the cured epoxy resins.

Further, it is known that the brittleness of cured epoxy resins, can be reduced by including a glycidyl-etherified polycondensation product of bisphenol A and formaldehyde in the epoxy resin formulation. However, when such a glycidyl-etherified polycondensation product of bisphenol A and formaldehyde and a bisphenol A-type epoxy resin are reacted with a polyhydric phenolic compound and if said glycidyl-etherified compound has a higher softening point than the bisphenol A-type epoxy resin, the amount of macromolecular components is increased in the resulting epoxy resin composition thus increasing the resin viscosity and thereby deteriorating not only the impregnation to glass cloth but also the prepreg stability. Further, when using glycidyl-etherified compounds having a lower softening point than the bisphenol A-type epoxy resin, the curing speed of the resulting epoxy resins is insufficient.

Therefore, it is an object of the present invention to provide epoxy resin compositions having well-balanced physical properties before and after the curing and which show excellent impregnation property into glass cloth and prepreg stability, excellent curing speed, thermal resistance, measling resistance, drilling workability, and excellent adhesion to copper foil. Such epoxy resin compositions are capable of providing cured products for use in the production of copper-plated, laminated epoxy resin sheets to be employed in printed-wiring boards.

Repetitive extensive research to find a solution of the above-mentioned technological problems has now succeeded in achieving the object by providing epoxy resin compositions comprising an epoxy resin, a curing agent, a curing accelerator and a solvent, characterized in that said epoxy resin comprises, as the principal component, an epoxy resin "a" having a hydrolyzable halogen content of 0.03% by weight and obtained by reacting, in the presence of basic catalyst, (I) a bisphenol A-type epoxy resin, (II) a glycidyl-etherified polycondensation product of bisphenol A and formaldehyde, having a softening point not higher than 50 °C, and (III) tetrabromobisphenol A, wherein the amount of compound (II) lies in the range of from 1% to 30% by weight, based on the total weight of the resin "a".

The bisphenol A-type epoxy resin (I) to be employed in the production of the epoxy resin "a" according to the present invention is a bifunctional epoxy resin having a bisphenol A compound skeleton. Such bifunctional epoxy resins are widely known in the art and are commercially available under various trade names.

The glycidyl-etherified polycondensation product (II) is obtained by using, as the base material, a polycondensation product obtained by reacting bisphenol A with formaldehyde, followed by glycidyl etherification thereof with the use of epichlorohydrin according to a method known in the art.

When using a glycidyl-etherified polycondensation product of bisphenol A and formaldehyde, having a higher softening point than 50 °C, the amount of macromolecular components increases in the resulting epoxy resin composition, thereby giving rise to defective properties such as elevated resin viscosity, deteriorated impregnation property into glass cloth and insufficient prepreg stability.

Preferably the glycidyl-etherified polycondensation product of bisphenol A and formaldehyde (II) for use in the production of the epoxy resin "a", has a softening point in the range of from 30 °C to 50 °C.

If the softening point of the glycidyl-etherified compound (II) is higher than 50 °C, the amount of macromolecular components in the resulting epoxy resin composition increases, which deteriorates the prepreg stability. If the softening point of the glycidyl-etherified compound (II) is 75 °C or higher, the macromolecular components in the resin also deteriorate the impregnation property to glass cloth.

Further, if the softening point of the glycidyl-etherified compound (II) is 30 °C or lower, the thermal resistance of the cured products of the resulting epoxy resin composition is unsatisfactory.

The epoxy resin "a" used in the present invention should have a hydrolyzable halogen content not higher than 0.03% by weight.

A higher hydrolyzable halogen content results in an insufficient improvement of the curing speed causing a poor balance between various physical properties of the cured epoxy resin composition.
Previously, a simultaneous improvement of the curing speed and of the prepreg stability could not be achieved. This technical problem has now been solved by using epoxy resin compositions according to the present invention, which show a well-balanced improvement between prepreg stability and curing speed.

In the epoxy resin compositions according to the present invention the epoxy resin "a" may be used as such or in combination with other epoxy resin(s) comprising two or more epoxy groups per molecule.

As the other epoxy resins various kinds of polyfunctional epoxy resins may be used such as, for example, glycidyl ether-type epoxy resins, such as bisphenol A-type epoxy resins, phenol novolak-type epoxy resins, cresol novolak-type epoxy resins, glycidyl ester-type epoxy resins, glycidyl amine-type epoxy resins, linear aliphatic epoxy resins, alicyclic epoxy resins, heterocyclic epoxy resins and halogenated epoxy resins. The amount of the other epoxy resins to be used in the epoxy resin compositions of the present invention should not be higher than 50% by weight based on the total weight of epoxy resin "a" and other epoxy resin (resins). If the amount of the other epoxy resins is higher than 50% by weight, the cured products will show a poor practical performance.

The curing agents which can be used in the epoxy resin compositions according to the present invention, are, for example, aromatic polyamines, dicyandiamide, acid anhydrides and various kinds of phenol-type novolak resins.

The epoxy resin compositions of the present invention also comprise a curing accelerator such as, for example, amines such as benzyldimethyl amine, and various kinds of imidazole compounds and tertiary phosphines such as triphenyl phosphine.

Solvents to be employed in the epoxy resin compositions of the present invention are, for example, acetone, methylethylketone, toluene, xylene, methylisobutylketone, ethyl acetate, ethylene glycol monomethyl ether, N,N-dimethylformamide, N,N-dimethylacetoamide, methanol and ethanol. These solvents may be used alone or in combination if desired.

If necessary, various kinds of additives may be added, to the epoxy resin compositions of the present invention, such as fire-retardants and fillers.

When using the epoxy resin compositions of the present invention in the manufacture of copper-plated laminated sheets, conventional methods may be used. For example, first the epoxy resin compositions are impregnated into and coated onto glass cloth, followed by heat drying, in order to remove the solvents therefrom, thereby forming prepregs. Next one or more of the thus formed prepregs are laminated with a copper foil being laid on one side or both sides of the resulting laminated prepregs, followed by heat-pressing and laminate moulding according to the conventional procedures.

The "pbw" and "%" used in the examples and comparative examples mean "part by weight" and "% by weight", respectively.

### EXAMPLE 1

20 pbw glycidyl-etherified polycondensation product of bisphenol A and formaldehyde (epoxy equivalent weight: 185, softening point: 30 °C and hydrolyzable chlorine content: 0.008%), 46 pbw bisphenol A-type epoxy resin (trade name "Epikote 828EL", epoxy equivalent: 187, and hydrolyzable chlorine content: 0.022%) and 34 pbw tetrabromobisphenol A were reacted in the presence of 0.03 pbw 2-ethyl-4-methylimidazole so as to obtain an epoxy resin having an epoxy equivalent weight of 445 and a hydrolyzable chlorine content of 0.015%. This epoxy resin is called "Epoxy Resin a¹".

100 pbw Epoxy Resin a¹, 3 pbw dicyandiamide as curing agent, and 0.15 pbw 2-ethyl-4-methylimidazole as curing accelerator were mixed together, followed by addition of a 1:1 solvent blend of methylethylketone/ethylene glycol monomethyl ether, so as to form a varnish having a nonvolatile content of 55%. The gel time thereof was determined, as shown in Table 2.

The resulting varnish was impregnated into and coated onto a glass cloth, followed by drying at 130 °C for five minutes, so as to obtain prepregs each having an epoxy resin composition content of 45%. Eight sheets of the thus prepared prepregs were laid one on top of the other and copper foils having a thickness of 0.35 µm were laid onto both sides of the thus formed laminated sheet, followed by laminate moulding at a temperature of 170 °C and a pressure of 40 kg/cm² for one hour, thus forming a copper-plated glass, laminated epoxy resin sheet having a thickness of 1.6 mm. The characteristic physical properties of the thus formed cured laminated sheet and those of the epoxy resin composition before curing are shown in Table 2.

"Hydrolyzable chlorine content" and "softening point" of the resin compositions and "prepreg stability" of the cured resins were determined according to the following test procedures:

### 1) Method for determining "hydrolyzable chlorine content":

Each of the samples under test was dissolved in a solvent blend of methylethylketone (25 ml) ethyleneglycol monobutylether (25 ml), followed by addition thereto of a 1N solution (25 ml) of NaOH in ethyleneglycol monobutylether, and then allowed to stand in a water-bath at 25 °C for 60 minutes. Thereafter, glacial acetic acid (25 ml) was added to the solution. The hydrolyzable chlorine content was then determined by potentiometry with the use of a 0.01N aqueous solution of silver nitrate.

### 2) Method for determining storage stability of prepregs:

Each of the prepregs under test was stored under atmospheric pressure for a period of fourteen days and then the gel time retention rate was determined.

### 3) Method for determining softening point:

The method specified in JIS K-7234 was followed.

### EXAMPLE 2

17 pbw glycidyl-etherified polycondensation product of bisphenol A and formaldehyde (epoxy equivalent weight: 194, softening point: 40 °C and hydrolyzable chlorine content: 0.007%), 49 pbw Epikote 828EL and 34 pbw tetrabromobisphenol A (34 parts), were reacted similar as in Example 1 so as to obtain an epoxy resin having an epoxy equivalent weight of 454 and a hydrolyzable chlorine content of 0.015%. The resulting epoxy resin is called "Epoxy Resin a²".

A varnish was prepared using Epoxy Resin a² in the same manner as in Example 1, from which a copper-plated glass, laminated epoxy sheet was prepared in a similar manner as in Example 1. The physical properties before curing of the epoxy resin composition and physical properties of the cured laminated sheet are shown in Table 2.

### Comparative Example 1

20 pbw glycidyl-etherified polycondensation product of bisphenol A and formaldehyde (epoxy equivalent weight: 206, softening point: 75 °C and hydrolyzable chlorine content: 0.01%), 46 pbw of Epikote 828EL and 34 pbw tetrabromobisphenol A were reacted in the same manner as in Example 1 so as to obtain an epoxy resin having an epoxy equivalent weight of 467 and a hydrolyzable chlorine content of 0.017%. The resulting epoxy resin is called "Epoxy Resin b¹".

### Comparative Example 2

17 pbw of a glycidyl-etherified polycondensation product of bisphenol A and formaldehyde (epoxy equivalent: 200, softening point: 60 °C and hydrolyzable chlorine content: 0.01%), 49 pbw of Epikote 828EL and 34 pbw tetrabromobisphenol A were reacted in a manner similar as in Example 1 so as to obtain an epoxy resin having an epoxy equivalent weight of 458 and a hydrolyzable chlorine content of 0.017%. The resulting epoxy resin is called "Epoxy Resin b²".

### Comparative Example 3

20 pbw of a glycidyl-etherified polycondensation product of bisphenol A and formaldehyde (the same compound as used in Example 1), 46 pbw of Epikote 828 (epoxy equivalent weight: 187 and hydrolyzable chlorine content: 0.061%) and 46 pbw tetrabromobisphenol A, were reacted in a manner similar as in Example 1 so as to obtain an epoxy resin having an epoxy equivalent weight of 444 and a hydrolyzable chlorine content of 0.035%. The resulting epoxy resin is called "Epoxy Resin b³".

### Comparative Example 4

17 pbw of a glycidyl-etherified polycondensation product of bisphenol A and formaldehyde (the same as used in Comparative Example 2), 49 pbw Epikote 828 and 34 pbw tetrabromobisphenol A were reacted in a manner similar as in Example 1 so as to obtain an epoxy resin having an epoxy equivalent weight of 459 and a hydrolyzable chlorine content of 0.037%. The resulting epoxy resin is called "Epoxy Resin b⁴".

### Comparative Example 5

20 pbw of a glycidyl-etherified polycondensation product of ortho-cresol and formaldehyde (trade name "Epikote 180S75", epoxy equivalent weight: 206, softening point: 74 °C and hydrolyzable chlorine content: 0.008%, a product by Yuka Shell Epoxy K.K.), 46 pbw Epikote 828EL and 34 pbw tetrabromobisphenol A were reacted in a manner similar as in Example 1 so as to obtain an epoxy resin having an epoxy equivalent weight of 466 and a hydrolyzable chlorine content of 0.015%. The resulting epoxy resin is called "Epoxy Resin b⁵".

### Comparative Example 6

20 pbw of an epoxy resin mixture of glycidyl-etherified polycondensation product of bisphenol A and formaldehyde (the same as used in Example 1), and 80 pbw brominated bisphenol A-type epoxy resin (trade name: "Epikote 5048", epoxy equivalent weight: 478, a product by Yuka Shell Epoxy K.K.), were reacted in a manner similar as in Example 1 so as to form an epoxy resin composition.

Varnishes were prepared using the epoxy resin compositions of comparative examples 1 to 6, from which copper-plated glass, laminated epoxy sheets were prepared in a similar manner as in Example 1. The characteristic properties before curing of the epoxy resin composition and physical properties of the cured laminated sheets are shown in Table 2.

The compositions of the epoxy resin compositions stated in the above-mentioned respective Examples and Comparative Examples are summarized in Table 1, while the physical properties before curing of the respective compositions and the physical properties of the cured laminated sheets are summarized in Table 2.

**Table 1**

| Epoxy Resin Compositions | Examples | | Comparatives Examples | | | | | |
|---|---|---|---|---|---|---|---|---|
| (parts by weight) | 1 | 2 | 1 | 2 | 3 | 4 | 5 | 6 |
| Epoxy Resin a¹ | 100 | | | | | | | |
| Epoxy Resin a² | | 100 | | | | | | |
| Epoxy Resin b¹ | | | 100 | | | | | |
| Epoxy Resin b² | | | | 100 | | | | |
| Epoxy Resin b³ | | | | | 100 | | | |
| Epoxy Resin b⁴ | | | | | | 100 | | |
| Epoxy Resin b⁵ | | | | | | | 100 | |
| Brominated Bisphenol A-type Epoxy Resin *1 | | | | | | | | 80 |
| Glycidyl-etherified Polycondensation Product of Bisphenol A and Formaldehyde *2 | | | | | | | | 20 |
| Dicyandiamide | 3 | 3 | 3 | 3 | 3 | 3 | 3 | 3 |
| 2-ethyl-4-methylimidazole | 0.15 | 0.15 | 0.15 | 0.15 | 0.15 | 0.15 | 0.15 | 0.15 |

| | | | | | | | | |
|---|---|---|---|---|---|---|---|---|
| *1 Trade name "Epikote 5048", a product by Yuka Shell Epoxy K.K. | | | | | | | | |
| *2 Epoxy equivalent: 185, softening point: 30 °C and hydrolyzable chlorine content: 0.08% | | | | | | | | |

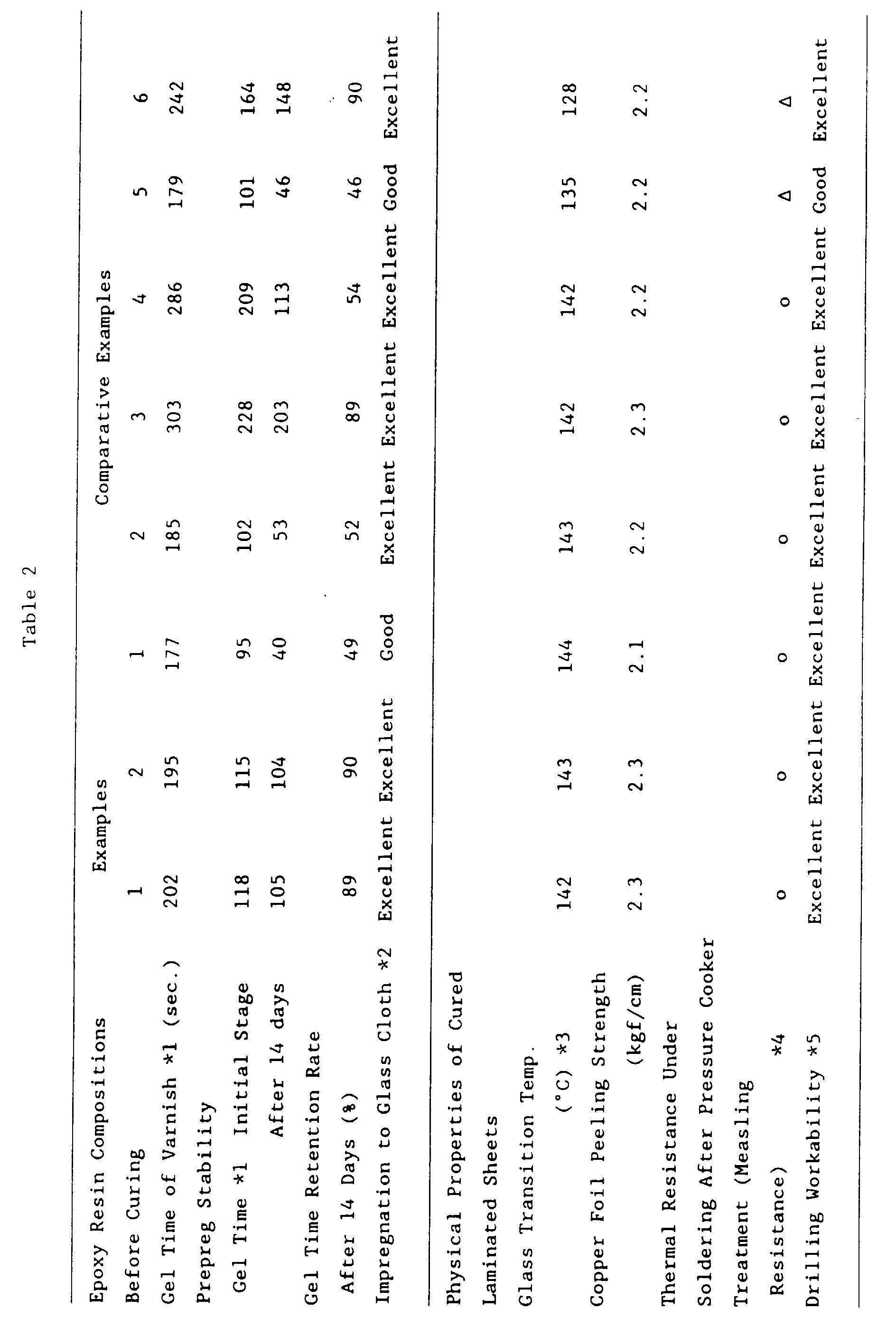

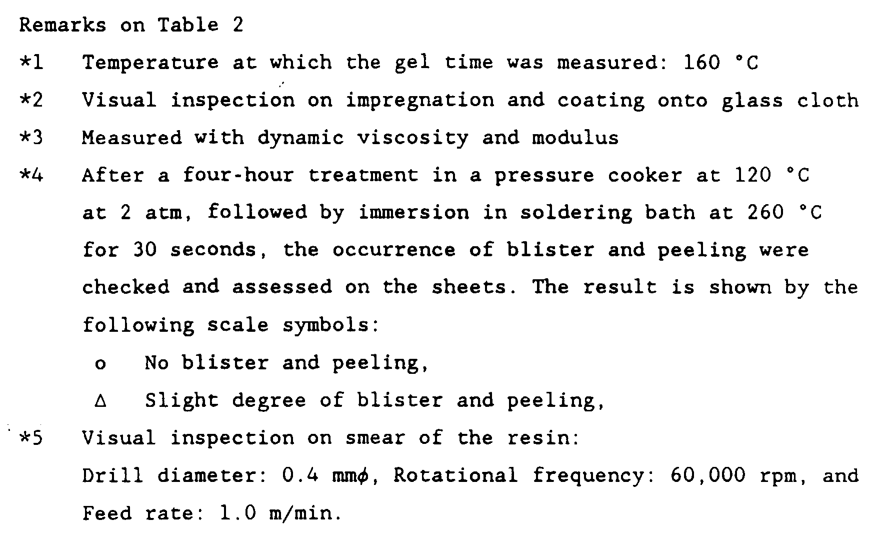

## Claims (Claims for the following Contracting State(s): BE, DE, FR, GB, IT, NL)

1. An epoxy resin composition comprising an epoxy resin, a curing agent, a curing accelerator and a solvent, characterized in that said epoxy resin comprises, as the principal component, an epoxy resin "a" having a hydrolyzable halogen content of 0.03% by weight determined according to the description and obtained by reacting, in the presence of basic catalyst, (I) a bisphenol A-type epoxy resin, (II) a glycidyl-etherified polycondensation product of bisphenol A and formaldehyde, having a softening point not higher than 50 °C (determined according to J is K-7234), and (III) tetrabromobisphenol A, wherein the amount of compound (II) lies in the range of from 1% to 30% by weight, based on the total weight of the resin "a".

2. An epoxy resin composition as claimed in claim 1 wherein the glycidyl-etherified polycondensation product of bisphenol A and formaldehyde (II), has a softening point of from 30 °C to 50 °C.

3. An epoxy resin composition as claimed in claim 1 or 2 wherein the epoxy resin consists for at least 50% by weight of epoxy resin "a".

4. An epoxy resin composition as claimed in any one of the claims 1 to 3 which comprises in addition to epoxy resin "a" at least one other epoxy resin comprising two or more epoxy groups per molecule.

5. An epoxy resin composition as claimed in claim 4 which comprises as the other type of epoxy resin(s) a polyfunctional epoxy resin selected from the group consisting of bisphenol A-type epoxy resins, glycidylester-type epoxy resins, glycidylamine-type epoxy resins, linear aliphatic epoxy resins, alicyclic epoxy resins, heterocyclic epoxy resins and halogenated epoxy resins.

6. An epoxy resin composition as claimed in any one of the claims 1 to 5 wherein the curing agent used is selected from the group consisting of aromatic polyamines, dicyandiamide, acid anhydrides and phenol novolak-type resins.

7. An epoxy resin composition as claimed in any one of the claims 1 to 6 wherein the curing accelerator used is selected from the group consisting of amines, imidazoles and phosphines.

8. An epoxy resin composition as claimed in claim 7 wherein the curing accelerator used is 2-ethyl-4-methylimidazole.

9. An epoxy resin composition as claimed in any one of the claims 1 to 8 wherein the solvent used is selected from the group consisting of acetone, methylethylketone, toluene, xylene, methylisobutylketone, ethylacetate, ethyleneglycolmonomethylether, N,N-dimethylformamide, N,N-dimethylacetoamide, methanol and ethanol or a mixture thereof.

10. Use of an epoxy resin composition as claimed in any one of the claims 1 to 9 for the preparation of a cured product.

## Claims (Claims for the following Contracting State(s): ES)

1. Process for the preparation of an epoxy resin composition by adding together an epoxy resin, a curing agent, a curing accelerator and a solvent, characterized in that said epoxy resin comprises, as the principal component, an epoxy resin "a" having a hydrolyzable halogen content of 0.03% by weight determined according to the description and obtained by reacting, in the presence of basic catalyst, (I) a bisphenol A-type epoxy resin, (II) a glycidyl-etherified polycondensation product of bisphenol A and formaldehyde, having a softening point not higher than 50 °C (determined according to J is K-7234), and (III) tetrabromobisphenol A, wherein the amount of compound (II) lies in the range of from 1% to 30% by weight, based on the total weight of the resin "a".

2. Process as claimed in claim 1 wherein the glycidyl-etherified polycondensation product of bisphenol A and formaldehyde (II), has a softening point of from 30 °C to 50 °C.

3. Process as claimed in claim 1 or 2 wherein the epoxy resin consists for at least 50% by weight of epoxy resin "a".

4. Process as claimed in any one of the claims 1 to 3 which comprises in addition to epoxy resin "a" at least one other epoxy resin comprising two or more epoxy groups per molecule.

5. Process as claimed in claim 4 which comprises as the other type of epoxy resin(s) a polyfunctional epoxy resin selected from the group consisting of bisphenol A-type epoxy resins, glycidylester-type epoxy resins, glycidylamine-type epoxy resins, linear aliphatic epoxy resins, alicyclic epoxy resins, heterocyclic epoxy resins and halogenated epoxy resins.

6. Process as claimed in any one of the claims 1 to 5 wherein the curing agent used is selected from the group consisting of aromatic polyamines, dicyandiamide, acid anhydrides and phenol novolak-type resins.

7. Process as claimed in any one of the claims 1 to 6 wherein the curing accelerator used is selected from the group consisting of amines, imidazoles and phosphines.

8. Process as claimed in claim 7 wherein the curing accelerator used is 2-ethyl-4-methylimidazole.

9. Process as claimed in any one of the claims 1 to 8 wherein the solvent used is selected from the group consisting of acetone, methylethylketone, toluene, xylene, methylisobutylketone, ethylacetate, ethyleneglycolmonomethylether, N,N-dimethylformamide, N,N-dimethylacetoamide, methanol and ethanol or a mixture thereof.

10. Process for the preparation of a cured product by curing an epoxy resin composition obtained by a process as claimed in any of the claims 1 to 9.

## Patentansprüche (Patentansprüche für folgende(n) Vertragsstaat(en): BE, DE, FR, GB, IT, NL)

1. Epoxidharzzusammensetzung, die ein Epoxidharz, einen Härter, einen Härtungsbeschleuniger und ein Lösungsmittel umfaßt, dadurch gekennzeichnet, daß das Epoxidharz als Hauptkomponente ein Epoxidharz "a" mit einem gemäß der Beschreibung ermittelten Gehalt an hydrolysierbarem Halogen von 0,03 Gew.-% beinhaltet, das durch Umsetzung, in Gegenwart von basischem Katalysator, von (I) einem Epoxidharz vom Bisphenol-A-Typ, (II) einem glycidylveretherten Polykondensationsprodukt aus Bisphenol-A und Formaldehyd mit einem Erweichungspunkt nicht über 50°C (ermittelt gemäß J is K-7234), sowie (III) Tetrabrombisphenol-A erhalten wird, wobei die Menge an Verbindung (II) im Bereich von 1 bis 30 Gew.-% liegt, bezogen auf das Gesamtgewicht an Harz "a".

2. Epoxidharzzusammensetzung nach Anspruch 1, wobei das glycidylveretherte Polykondensationsprodukt aus Bisphenol-A und Formaldehyd (II) einen Erweichungspunkt von 30°C bis 50°C aufweist.

3. Epoxidharzzusammensetzung nach Anspruch 1 oder 2, wobei das Epoxidharz zu mindestens 50 Gew.-% aus Epoxidharz "a" besteht.

4. Epoxidharzzusammensetzung nach einem der Ansprüche 1 bis 3, die neben Epoxidharz "a" mindestens ein weiteres Epoxidharz umfaßt, das zwei oder mehr Epoxidgruppen je Molekül enthält.

5. Epoxidharzzusammensetzung nach Anspruch 4, die als den weiteren Epoxidharztyp ein polyfunktionelles Epoxidharz umfaßt, das aus der Reihe Epoxidharze vom Bisphenol-A-Typ, Epoxidharze vom Glycidylester-Typ, Epoxidharze vom Glycidylamin-Typ, lineare aliphatische Epoxidharze, alicyclische Epoxidharze, heterocyclische Epoxidharze und halogenierte Epoxidharze gewählt wird.

6. Epoxidharzzusammensetzung nach einem der Ansprüche 1 bis 5, wobei der eingesetzte Härter aus der Reihe aromatische Polyamine, Dicyandiamid, Säureanhydride und Harze vom Phenol-Novolak-Typ gewählt wird.

7. Epoxidharzzusanmensetzung nach einem der Ansprüche 1 bis 6, wobei der eingesetzte Härtungsbeschleuniger aus der Reihe der Amine, Imidazole und Phosphine gewählt wird.

8. Epoxidharzzusammensetzung nach Anspruch 7, wobei als Härtungsbeschleuniger 2-Ethyl-4-methylimidazol eingesetzt wird.

9. Epoxidharzzusammensetzung nach einem der Ansprüche 1 bis 8, wobei das eingesetzte Lösungsmittel aus der Reihe Aceton, Methylethylketon, Toluol, Xylol, Methylisobutylketon, Ethylacetat, Ethylenglykolmonomethylether, N,N-Dimethylformamid, N,N-Dimethylacetamid, Methanol und Ethanol oder einer Mischung aus diesen gewählt wird.

10. Verwendung einer Epoxidharzzusammensetzung gemäß einem der Ansprüche 1 bis 9 zur Herstellung eines gehärteten Produkts.

## Patentansprüche (Patentansprüche für folgende(n) Vertragsstaat(en): ES)

1. Verfahren zur Herstellung einer Epoxidharzzusammensetzung durch Vereinigung eines Epoxidharzes, eines Härters, eines Härtungsbeschleunigers und eines Lösungsmittels, dadurch gekennzeichnet, daß das Epoxidharz als Hauptkomponente ein Epoxidharz "a" mit einem gemäß der Beschreibung ermittelten Gehalt an hydrolysierbarem Halogen von 0,03 Gew.-% beinhaltet, das durch Umsetzung, in Gegenwart von basischem Katalysator, von (I) einem Epoxidharz vom Bisphenol-A-Typ, (II) einem glycidylveretherten Polykondensationsprodukt aus Bisphenol-A und Formaldehyd mit einem Erweichungspunkt nicht über 50°C (ermittelt gemäß J is K-7234), sowie (III) Tetrabrombisphenol-A erhalten wird, wobei die Menge an Verbindung (II) im Bereich von 1 bis 30 Gew.-% liegt, bezogen auf das Gesamtgewicht an Harz "a".

2. Verfahren nach Anspruch 1, wobei das glycidylveretherte Polykondensationsprodukt aus Bisphenol-A und Formaldehyd (II) einen Erweichungspunkt von 30°C bis 50°C aufweist.

3. Verfahren nach Anspruch 1 oder 2, wobei das Epoxidharz zu mindestens 50 Gew.-% aus Epoxidharz "a" besteht.

4. Verfahren nach einem der Ansprüche 1 bis 3, das neben Epoxidharz "a" mindestens ein weiteres Epoxidharz umfaßt, das zwei oder mehr Epoxidgruppen je Molekül enthält.

5. Verfahren nach Anspruch 4, das als den weiteren Epoxidharztyp ein polyfunktionelles Epoxidharz umfaßt, das aus der Reihe Epoxidharze vom Bisphenol-A-Typ, Epoxidharze vom Glycidylester-Typ, Epoxidharze vom Glycidylamin-Typ, lineare aliphatische Epoxidharze, alicyclische Epoxidharze, heterocyclische Epoxidharze und halogenierte Epoxidharze gewählt wird.

6. Verfahren nach einem der Ansprüche 1 bis 5, wobei der eingesetzte Härter aus der Reihe aromatische Polyamine, Dicyandiamid, Säureanhydride und Harze vom Phenol-Novolak-Typ gewählt wird.

7. Verfahren nach einem der Ansprüche 1 bis 6, wobei der eingesetzte Härtungsbeschleuniger aus der Reihe der Amine, Imidazole und Phosphine gewählt wird.

8. Verfahren nach Anspruch 7, wobei als Härtungsbeschleuniger 2-Ethyl-4-methylimidazol eingesetzt wird.

9. Verfahren nach einem der Ansprüche 1 bis 8, wobei das eingesetzte Lösungsmittel aus der Reihe Aceton, Methylethylketon, Toluol, Xylol, Methylisobutylketon, Ethylacetat, Ethylenglykolmonomethylether, N,N-Dimethylformamid, N,N-Dimethylacetamid, Methanol und Ethanol oder einer Mischung aus diesen gewählt wird.

10. Verfahren zur Herstellung eines gehärteten Produkts durch Härtung einer durch ein Verfahren gemäß einem der Ansprüche 1 bis 9 erhaltenen Epoxidharzzusammensetzung.

## Revendications (Revendications pour l'(les) Etat(s) contractant(s) suivant(s): BE, DE, FR, GB, IT, NL)

1. Composition de résine époxy, qui comprend une résine époxy, un agent de durcissement, un accélérateur de durcissement et un solvant, caractérisée en ce que ladite résine époxy comprend, à titre de composant principal, une résine époxy "a" possédant une teneur en halogènes hydrolysables de 0,03% en poids, déterminée selon la méthode décrite dans la description et obtenue par la réaction, en présence d'un catalyseur basique, (I) d'une résine époxy du type bisphénol-A, (II) d'un produit de polycondensation éthérifé par des radicaux glycidyle de bisphénol-A et de formaldéhyde, possédant un point de ramollissement non supérieur à 50°C (déterminé selon la norme JIS K-7234) et (III) du tétrabromobisphénols-A, où la proportion du composé (II) se situe dans la plage de 1% à 30% en poids, sur base du poids total de la résine "a".

2. Composition de résine époxy suivant la revendication 1, caractérisée en ce que le produit de polycondensation éthérifié par des radicaux glycidyle du bisphénol-A et du formaldéhyde (II) possède un point de ramollissement de 30°C à 50°C.

3. Composition de résine époxy suivant la revendication 1 ou 2, caractérisée en ce que la résine époxy est constituée pour au moins 50% en poids de résine époxy "a".

4. Composition de résine époxy suivant l'une quelconque des revendications 1 à 3, caractérisée en ce qu'elle comprend, en plus de la résine époxy "a", au moins une autre résine époxy possédant deux ou plus de deux radicaux époxy par molécule.

5. Composition de résine époxy suivant la revendication 4, caractérisée en ce qu'elle comprend, à titre d'autre type de résine(s) époxy, une résine époxy polyfonctionnelle choisie dans le groupe formé par les résines époxy du type bisphénol-A, les résines époxy du type ester glycidylique, les résines époxy du type glycidylamine, les résines époxy aliphatiques linéaires, les résines époxy alicycliques, les résines époxy hétérocycliques et les résines époxy halogénées.

6. Composition de résine suivant l'une quelconque des revendications 1 à 5, caractérisée en ce que l'agent de durcissement employé est choisi dans le groupe formé par les polyamines aromatiques, le dicyandiamide, les anhydrides d'acides et les résines du type phénol novolaque.

7. Composition de résine époxy suivant l'une quelconque des revendications 1 à 6, caractérisée en ce que l'accélérateur de durcissement employé est choisi dans le groupe formé par les amines, les imidazoles et les phosphines.

8. Composition de résine époxy suivant la revendication 7, caractérisée en ce que l'accélérateur de durcissement employé est le 2-éthyl-4-méthylimidazole.

9. Composition de résine époxy suivant l'une quelconque des revendications 1 à 8, caractérisée en ce que le solvant employé est choisi dans le groupe formé par l'acétone, la méthyléthylcétone, le toluène, le xylène, la méthylisobutylcétone, l'acétate d'éthyle, l'éther monométhylique de l'éthylèneglycol, le N,N-diméthylformamide, le N,N-diméthylacétamide, le méthanol et l'éthanol, ou leurs mélanges.

10. Utilisation d'une composition de résine époxy suivant l'une quelconque des revendications 1 à 9 pour la fabrication d'un produit durci.

## Revendications (Revendications pour l'(les) Etat(s) contractant(s) suivant(s): ES)

1. Procédé de préparation d'une composition de résine époxy par l'addition mutuelle d'une résine époxy, d'un agent de durcissement, d'un accélérateur de durcissement et d'un solvant, caractérisé en ce que la résine époxy précitée comprend, à titre de composant essentiel, une résine époxy "a" possédant une teneur en halogènes hydrolysables de 0,03% en poids, déterminée selon la méthode décrite dans la description et obtenue par la réaction, en présence d'un catalyseur basique, (I) d'une résine époxy du type bisphénol-A, (II) d'un produit de polycondensation éthérifé par des radicaux glycidyle de bisphénol-A et de formaldéhyde, possédant un point de ramollissement non supérieur à 50°C (déterminé selon la norme JIS K-7234) et (III) du tétrabromobisphénols-A, où la proportion du composé (II) se situe dans la plage de 1% à 30% en poids, sur base du poids total de la résine "a".

2. Procédé suivant la revendication 1, caractérisé en ce que le produit de polycondensation éthérifié par des radicaux glycidyle du bisphénol-A et du formaldéhyde (II) possède un point de ramollissement de 30°C à 50°C.

3. Procédé suivant la revendication 1 ou 2, caractérisé en ce que la résine époxy est constituée pour au moins 50% en poids de résine époxy "a".

4. Procédé suivant l'une quelconque des revendications 1 à 3, caractérisé en ce qu'il comprend, en plus de la résine époxy "a", au moins une autre résine époxy possédant deux ou plus de deux radicaux époxy par molécule.

5. Procédé suivant la revendication 4, caractérisé en ce qu'il comprend, à titre d'autre type de résine(s) époxy, une résine époxy polyfonctionnelle choisie dans le groupe formé par les résines époxy du type bisphénol-A, les résines époxy du type ester glycidylique, les résines époxy du type glycidylamine, les résines époxy aliphatiques linéaires, les résines époxy alicycliques, les résines époxy hétérocycliques et les résines époxy halogénées.

6. Procédé suivant l'une quelconque des revendications 1 à 5, caractérisé en ce que l'agent de durcissement employé est choisi dans le groupe formé par les polyamines aromatiques, le dicyandiamide, les anhydrides d'acides et les résines du type phénol novolaque.

7. Procédé suivant l'une quelconque des revendications 1 à 6, caractérisé en ce que l'accélérateur de durcissement employé est choisi dans le groupe formé par les amines, les imidazoles et les phosphines.

8. Procédé suivant la revendication 7, caractérisé en ce que l'accélérateur de durcissement employé est le 2-éthyl-4-méthylimidazole.

9. Procédé suivant l'une quelconque des revendications 1 à 8, caractérisé en ce que le solvant employé est choisi dans le groupe formé par l'acétone, la méthyléthylcétone, le toluène, le xylène, la méthylisobutylcétone, l'acétate d'éthyle, l'éther monométhylique de l'éthylèneglycol, le N,N-diméthylformamide, le N,N-diméthylacétamide, le méthanol et l'éthanol, ou leurs mélanges.

10. Procédé de préparation d'un produit durci par le durcissement d'une composition de résine époxy suivant l'une quelconque des revendications 1 à 9.
